# EUROPEAN PATENT APPLICATION

(11) **EP 3 637 213 A1**
(43) Date of publication of application: **15.04.2020**
(21) Application number: 18813705.3
(22) Date of filing: 11.06.2018
(51) Int. Cl.: G05D 1/02, B25J 9/16, B25J 13/08, G01C 21/00, G01C 21/20, G01R 33/00, G06K 19/06, G06K 7/08

(54) **MODULAR LANDMARK FOR ROBOT MOVEMENT, LANDMARK, AND ROBOT**

(30) Priority: 09.06.2017 CN 201710437399
(71) Applicant: Zhejiang Libiao Robots Co., Ltd., Zhejiang 310000 (CN); Zhu, Jianqiang, Zhejiang 310000 (CN)
(72) Inventor: Zhejiang Libiao Robots Co., Ltd., Zhejiang 310000 (CN); Zhu, Jianqiang, Zhejiang 310000 (CN)
(74) Representative: Grünecker Patent- und Rechtsanwälte PartG mbB
(86) International application number: PCT/CN2018/090705
(87) International publication number: WO 2018/224047

(57) **Abstract**

A modular placemark for robot movement divides an entire region in which a robot moves into multiple modular zones. Each modular zone is provided therein with a first magnetic block having a north-pole polarity or a south-pole polarity and a second magnetic block having a polarity different from the polarity of the first magnetic block. Also disclosed are a placemark for robot movement and a robot.

## Description

### Cross-reference to Related Applications

The present disclosure claims the priority of the Chinese patent application No. CN201710437399.3, filed with the Chinese Patent Office on June 9, 2017 and entitled "Modular Landmark for Robot Movement, Landmark, and Robot", which is incorporated herein by reference in its entirety.

### Technical Field

The present disclosure relates to a modular placemark (landmark) for robot movement (marching), a placemark, and a robot.

### Background Art

Robots can be navigated in a variety of ways, for example by GPS or by placemarks, when transporting and unloading goods. When a robot is used to sort packages, one sorting system has hundreds of robots in movement at the same time. At present, a relatively general practice for navigation is to collect placemark information. What is most common in placemark information is a two-dimensional code (QR code), which includes both a direction signal and a position signal. When moving from one modular zone (region) to another modular zone, the robot constantly reads the information of the two-dimensional code, and moves straight, moves backwards or makes a turn according to instructions. The two-dimensional code has a relatively good error-tolerant rate, and can also be decoded on the premise that the information is partially lost. The information of the four corners of the two-dimensional code represents the direction information which can be used for direction judgment of the robot. When the information of one of the four corners of the two-dimensional code fails to be read, it is impossible to judge the direction. Since the two-dimensional code may be worn or covered by foreign objects, or due to other reasons, there may occur a reading failure.

### Summary

In view of the above deficiencies, the present disclosure provides a modular placemark for robot movement, in which a magnetic material is used for navigating a robot.

The technical solution of the present disclosure is:
A modular placemark for robot movement, dividing into multiple modular zones an entire region in which a robot moves, wherein each modular zone is provided therein with:
a first magnetic block which has a north-pole polarity or a south-pole polarity; and
a second magnetic block which has a polarity different from the polarity of the first magnetic block.

It should be noted that navigation may be performed on the robot just by the two magnetic blocks of different polarities, the positions of the two magnetic blocks may be set arbitrarily, and the magnetic blocks may have a variety of shapes, and accordingly, the robot has a magnetic induction sensors matched therewith.

Preferably, the first magnetic block is a first magnetic strip and the second magnetic block is a second magnetic strip, in order to improve the utilization rate of the magnetic blocks, increase the coverage area in an orientation and facilitate the identification by the robot.

It should be noted that the magnetic blocks have an arbitrary shape, the magnetic strips may have a rectangular shape, and when the magnetic blocks are provided as magnetic strips, the positions of the two magnetic strips may also be set arbitrarily.

Preferably, the first magnetic strip is arranged in the Y-axis direction and the second magnetic strip is arranged in the X-axis direction.

It should be noted that the first magnetic strip and the second magnetic strip are arranged according to the principle of plane coordinates, and the arrangement of plane coordinates enables determination of the position and moving direction of a robot entering an area of the coordinates. The robot may determine to move forward, move backward or make a turn according to the instructions. The first magnetic strip and the second magnetic strip may or may not intersect. If they intersect, the position of the intersection point is equivalent to the origin of the coordinates. Due to an overlap of north-pole and/or south-pole, the magnetic induction sensors on the robot cannot collect signals of the intersection point, resulting in a waste of the magnetic strips and the magnetic induction sensors. Therefore, a structure in which the first magnetic strip and the second magnetic strip do not intersect can be selected, and the position of the intersection point can be obtained by calculation.

Preferably, the modular placemark for robot movement further comprises:
a third magnetic strip, which is arranged in the X-axis direction and has the same polarity as the second magnetic strip.

It should be noted that the length of the first magnetic strip may be equal to the length of the second magnetic strip plus the length of the third magnetic strip, and such structure has relatively good symmetry; and the first magnetic strip, the second magnetic strip and the third magnetic strip may also have an equal length, and in this case, the magnetic strip in the X-axis direction is larger than the magnetic strip in the Y-axis direction, the adjustment accuracy in the X-axis direction of the robot is higher than that in the Y-axis direction, and the solution in which the robot takes the Y-axis direction as the main moving direction is a preferable solution.

Further, the modular placemark for robot movement further comprises:
a fourth magnetic strip, which is arranged in the Y-axis direction and has the same polarity as the second magnetic strip and the third magnetic strip.

The magnetic strips having different polarities do not intersect, and the magnetic strips having the same polarity may or may not intersect.

The first magnetic strip, the second magnetic strip, the third magnetic strip and the fourth magnetic strip are arranged in a cruciform shape.

The lengths between the center of the cruciform shape and the distal-most end of each of the first magnetic strip, the second magnetic strip, the third magnetic strip, and the fourth magnetic strip are equal.

The magnetic strips are directly pasted onto the respective modular zones.

The magnetic strips substantially do not affect the movement of the robot, when they are relatively thin, or the wheels of the robot may select to avoid the magnetic strips.

Each of the modular zones is provided with a magnetic material plate, wherein the magnetic material plate is directly magnetized to form the north-pole magnetic strip or south-pole magnetic strip.

In order to facilitate the mounting and magnetization, a magnetic material plate is selected, and the magnetic material plate may have a size covering the whole modular zone or may occupy only the central area of the modular zone.

Preferably, the multiple modular zones are arranged in a matrix, and each modular zone has a square shape.

The present disclosure further provides a placemark for robot movement, comprising the modular placemark for robot movement, and also comprising address placemarks, wherein each of the modular zones is provided with a different address placemark.

The modular placemark can only provide position and direction within a respective modular zone, while the address placemark can provide the exact position of the modular zone in the entire region.

The address placemark is a bar code, a two-dimensional code, a graphic mark, a color mark, a size mark, or a radio frequency identification (RFID) mark.

In addition, the present disclosure further provides a robot, which identifies placemark information by arrangement of Hall sensors.

The robot moves on the placemark for robot movement, wherein a plurality of magnetic induction sensors and an address placemark identification device are mounted at the bottom of the robot, the plurality of magnetic induction sensors can collect signals of the magnetic strips having different polarities, the address placemark identification device can collect information on the address placemarks, the plurality of magnetic induction sensors and the address placemark identification device are connected with a robot controller, and the robot is configured to move forward, move backward and/or make a turn according to the instructions and the collected placemark information, to reach a target modular zone.

Preferably, the magnetic induction sensors are Hall sensors.

The position and direction of the robot in a modular zone can be determined, as long as the signals of two magnetic strips having different polarities can be collected by the plurality of Hall sensors. The plurality of Hall sensors may be arranged in various ways, e.g., being arranged in a straight line, in an angular line, in a curve, in a circle, etc.

The address placemark identification device is a camera or an RFID card reader. The camera is configured to collect signals of a bar code, a two-dimensional code, a graphic mark, a color mark, and/or a size mark, and the RFID card reader is configured to collect RFID signals.

Preferably, the plurality of Hall sensors are arranged in a form of square, and the address placemark identification device is located at the center of the square. When the Hall sensors are arranged in a form of square, they can cover a relatively large area, and can easily collect the signals of the magnetic strips. As the robot moves, variations may occur in the output signals of the plurality of Hall sensors, and in this way, it is possible to obtain the accurate position of the robot.

In order to improve the sensitivity of magnetic signal collection, the robot further comprises a low-remanence high-permeability material plate, the Hall sensors are mounted to be close to the respective modular zones, and the low-remanence high-permeability material plate is fixed above and close to the Hall sensors.

The robot includes a sorting robot and/or a robot for transporting and unloading goods. The robot is wirelessly connected with a server, and after receiving an instruction signal, the robot moves forward, moves backward, and/or makes a turn along a predetermined route to reach a target modular zone, unloads the goods to a position having an appropriate distance from the robot, and finally returns to load goods.

The present disclosure employs the technical solution in which the magnetic strips cooperate with the Hall sensors, which enables a larger coverage area than the technical solution in which only two-dimensional codes are used, and is immune to the influence of dust or covering by the foreign objects.

The present disclosure has the advantageous effects of simple structure, low cost, reliable and accurate positioning and convenient maintenance.

### Brief Description of Drawings

FIG. 1 is a schematic structural diagram showing the arrangement of a first magnetic strip and a second magnetic strip in a modular placemark of the present disclosure.
FIG. 2 is a schematic structural diagram showing the addition of a third magnetic strip on the basis of FIG. 1.
FIG. 3 is a schematic structural diagram showing the addition of a fourth magnetic strip on the basis of FIG. 2.
FIG. 4 is a schematic structural diagram of the modular placemark of the present disclosure in which the magnetic strips having different polarities do not intersect and the magnetic strips having the same polarity intersect.
FIG. 5 is a schematic structural diagram showing a robot of the present disclosure moving on a placemark.
FIG. 6 is a schematic structural diagram showing the correlation of the magnetic strips, Hall sensors, and a low-remanence high-permeability material plate according to the present disclosure.

### Detailed Description of Embodiments

The present disclosure is now further described with reference to the accompanying drawings:
As shown in the figures, Embodiment 1: a modular placemark for robot movement, dividing an entire region in which a robot moves into multiple modular zones, wherein each modular zone is provided therein with:
a first magnetic block which has a north-pole polarity or a south-pole polarity; and
a second magnetic block which has a polarity different from the polarity of the first magnetic block.

The first magnetic block is a first magnetic strip 1 and the second magnetic block is a second magnetic strip 2.

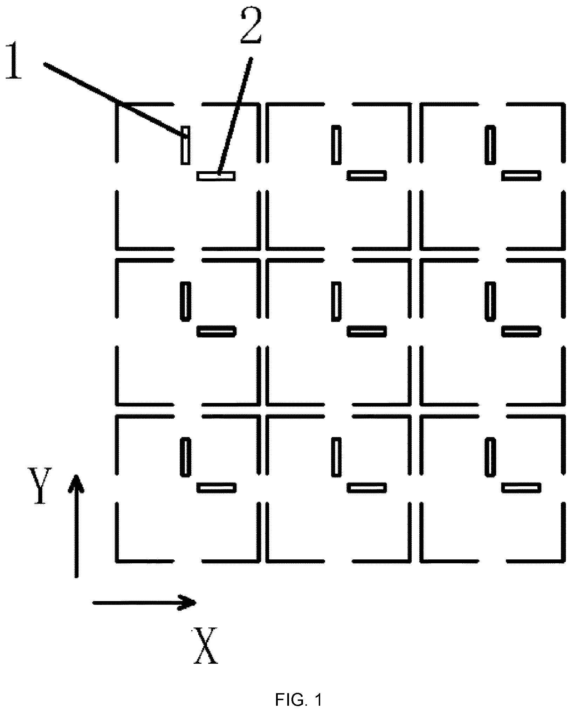

The first magnetic strip 1 is arranged in the Y-axis direction and the second magnetic strip 2 is arranged in the X-axis direction (as shown in FIG. 1).

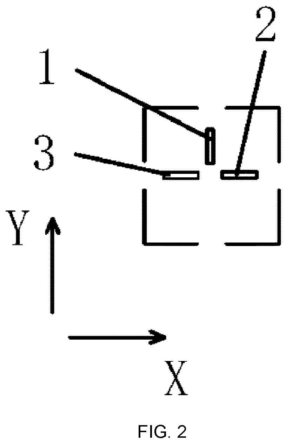

Embodiment 2: on the basis of Embodiment 1, the modular placemark further includes:
a third magnetic strip 3, which is arranged in the X-axis direction and has the same polarity as the second magnetic strip 2 (as shown in FIG. 2).

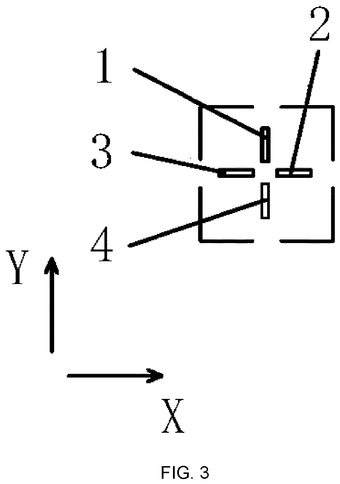

Embodiment 3: on the basis of Embodiment 2, the modular placemark further includes:
a fourth magnetic strip 4, which is arranged in the Y-axis direction and has the same polarity as the second magnetic strip 2 and the third magnetic strip 3 (as shown in FIG. 3).

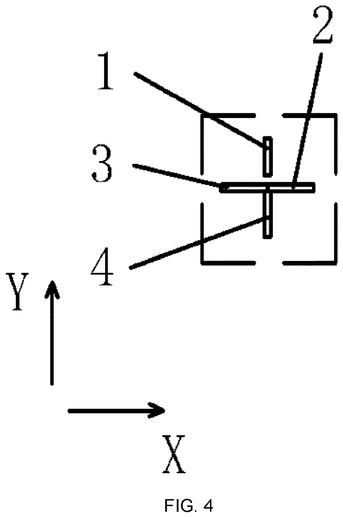

The magnetic strips having different polarities do not intersect, and the magnetic strips having the same polarity may intersect (as shown in FIG. 4) or may not intersect.

The first magnetic strip 1, the second magnetic strip 2, the third magnetic strip 3 and the fourth magnetic strip 4 are arranged in a cruciform shape.

The lengths between the center of the cruciform shape and the distal-most end of each of the first magnetic strip 1, cruciform shapethe second magnetic strip 2, cruciform shapethe third magnetic strip 3, and cruciform shapethe fourth magnetic strip 4 are equal.

The magnetic strips are directly pasted onto the respective modular zones, or each of the modular zones may be equipped with a magnetic material plate that is directly magnetized to form the north-pole strip or the south-pole magnetic strip.

The multiple modular zones are arranged in a matrix, and each modular zone has a square shape.

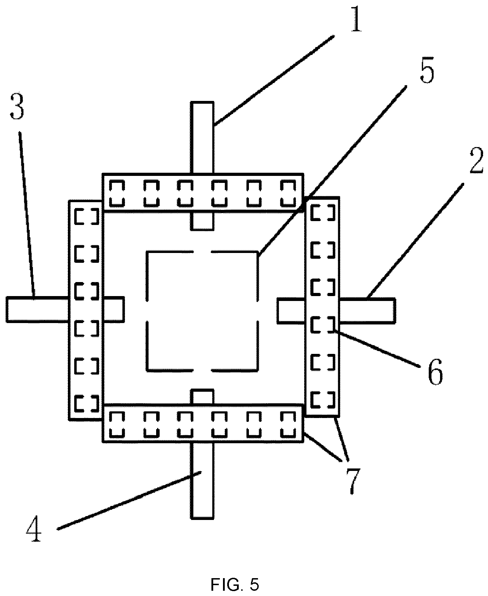

A placemark for robot movement, comprising the modular placemark for robot movement, and also comprising address placemarks 5, wherein each of the modular zones is provided with a different address placemark 5 (as shown in FIG. 5).

The address placemark 5 is a bar code, a two-dimensional code, a graphic mark, a color mark, a size mark, or an RFID (Radio Frequency Identification) mark.

A robot, moving on the placemark for robot movement, wherein a plurality of magnetic induction sensors and an address placemark identification device are mounted at the bottom of the robot, wherein the plurality of magnetic induction sensors can collect signals of the magnetic strips having different polarities, the address placemark identification device can collect information on the address placemarks, the plurality of magnetic induction sensors and the address placemark identification device are connected to a robot controller, and the robot is configured to move forward, move backward and make a turn according to the instructions and the collected information on the address placemarks, to reach a target modular zone.

The plurality of magnetic induction sensors are Hall sensors 6. The Hall sensors are generally 0.5-2 cm away from the ground, and can collect the signals of the magnetic strips without contact. The Hall will have a different voltage output when a north-pole magnetic signal or south-pole magnetic signal is collected.

The address placemark identification device is a camera or an RFID card reader.

The plurality of Hall sensors are arranged in a form of square, and the address placemark identification device is located at the center of the square (as shown in FIG. 5).

As can be seen from FIG. 5, the robot can also be positioned without providing the fourth magnetic strip 4 and the third magnetic strip 3.

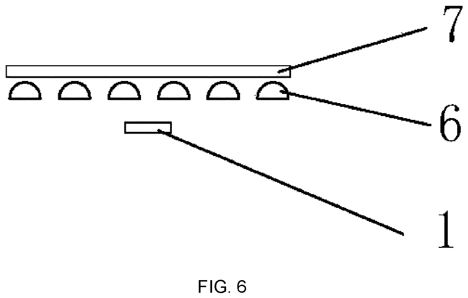

The robot further includes a low-remanence high-permeability material plate 7, the Hall sensors 6 are mounted to be close to the respective modular zones, and the low-remanence high-permeability material plate 7 is fixed above and close to the Hall sensors 6 (as shown in FIG. 6).

The robot includes a sorting robot and/or a robot for transporting and unloading goods. The robot is wirelessly connected with a server, and after receiving an instruction signal, the robot moves forward, moves backward, and makes a turn along a predetermined route to reach a target modular zone to load or unload goods.

## Claims

1. A modular placemark for robot movement, **characterized by** dividing into multiple modular zones an entire region in which a robot moves, wherein each modular zone is provided therein with:
a first magnetic block, which has a north-pole polarity or a south-pole polarity;
a second magnetic block, which has a polarity different from the polarity of the first magnetic strip;

2. The modular placemark for robot movement according to claim 1, wherein the first magnetic block is a first magnetic strip (1) and the second magnetic block is a second magnetic strip (2).

3. The modular placemark for robot movement according to claim 2, wherein the first magnetic strip (1) is arranged in the Y-axis direction and the second magnetic strip (2) is arranged in the X-axis direction.

4. The modular placemark for robot movement according to claim 3, further comprising a third magnetic strip (3), which is arranged in the X-axis direction and the third magnetic strip (3) has the same polarity as the second magnetic strip (2).

5. The modular placemark for robot movement according to claim 4, further comprising a fourth magnetic strip (4), which is arranged in the Y-axis direction and the fourth magnetic strip (4) has the same polarity as the second magnetic strip (2) and the third magnetic strip (3).

6. The modular placemark for robot movement according to claim 5, wherein magnetic strips having different polarities are configured not to intersect, and magnetic strips having the same polarity are configured to intersect or not to intersect.

7. The modular placemark for robot movement according to claim 6, wherein the first magnetic strip (1), the second magnetic strip (2), the third magnetic strip (3) and the fourth magnetic strip (4) are arranged in a cruciform shape.

8. The modular placemark for robot movement according to claim 7, wherein the lengths between a center of the cruciform shape and a distal-most end of each of the first magnetic strip (1), the second magnetic strip (2), the third magnetic strip (3), and the fourth magnetic strip (4) are the same.

9. The modular placemark for robot movement according to any one of claims 2-8, wherein the magnetic strips are directly pasted onto the respective modular zones.

10. The modular placemark for robot movement according to any one of claims 2-8, wherein each of the modular zones is provided with a magnetic material plate, wherein the magnetic material plate is directly magnetized to form the north-pole magnetic strip or south-pole magnetic strip.

11. The modular placemark for robot movement according to any one of claims 2-8, wherein the multiple modular zones are arranged in a matrix, and each modular zone has a square shape.

12. A placemark for robot movement, **characterized by** comprising the modular placemark for robot movement according to any one of claims 1-11, and further comprising address placemarks (5), wherein each of the modular zones is provided with a different address placemark (5).

13. The placemark for robot movement according to claim 12, wherein the address placemark (5) is a bar code, a two-dimensional code, a graphic mark, a color mark, a size mark, or an RFID mark.

14. A robot, moving on the placemark for robot movement according to any one of claims 11-13, **characterized in that** a plurality of magnetic induction sensors and an address placemark identification device are mounted at a bottom of the robot, wherein the plurality of magnetic induction sensors can collect signals of the magnetic strips having different polarities, the address placemark identification device can collect information on the address placemarks, the plurality of magnetic induction sensors and the address placemark identification device are connected with a robot controller, and the robot is configured to move forward, move backward and/or make a turn according to instructions and the collected information on the address placemarks, to reach a target modular zone.

15. The robot according to claim 14, wherein the plurality of magnetic induction sensors are Hall sensors (6).

16. The robot according to claim 14, wherein the address placemark identification device is a camera or an RFID card reader.

17. The robot according to claim 15 or 16, wherein the plurality of Hall sensors are arranged in a form of square, and the address placemark identification device is located at a center of the square.

18. The robot according to claim 17, further comprising a low-remanence high-permeability material plate (7), the Hall sensors (6) are mounted to be close to the respective modular zones, and the low-remanence high-permeability material plate (7) is fixed above the Hall sensors (6) and close to the Hall sensors (6).

19. The robot according to claim 14, wherein the robot comprises a sorting robot and/or a robot for transporting and unloading goods, wherein the sorting robot and/or the robot for transporting and unloading goods are wirelessly connected with a server, and after receiving an instruction signal, move forward, move backward, and/or make a turn along a predetermined route to reach a target modular zone to load or unload goods.

## Amended claims

### Amended claims under Art. 19.1 PCT

1. A modular placemark for robot movement, **characterized by** dividing into multiple modular zones an entire region in which a robot moves, wherein each modular zone is provided therein with:
a first magnetic strip (1), which has a north-pole polarity or a south-pole polarity detectable by a magnetic induction sensor and is arranged in a Y-axis direction;
a second magnetic strip (2), which has a polarity different from the polarity of the first magnetic strip and is arranged in a X-axis direction;
a third magnetic strip (3), which has the same polarity as the second magnetic strip (2) and is arranged in the X-axis direction; and
a fourth magnetic strip (4), which has the same polarity as the second magnetic strip (2) and the third magnetic strip (3) and is arranged in the Y-axis direction.

2. The modular placemark for robot movement according to claim 1, wherein magnetic strips having different polarities are configured not to intersect, and magnetic strips having the same polarity are configured to intersect or not to intersect.

3. The modular placemark for robot movement according to claim 2, wherein the first magnetic strip (1), the second magnetic strip (2), the third magnetic strip (3) and the fourth magnetic strip (4) are arranged in a cruciform shape.

4. The modular placemark for robot movement according to claim 3, wherein the lengths between a center of the cruciform shape and a distal-most end of each of the first magnetic strip (1), the second magnetic strip (2), the third magnetic strip (3), and the fourth magnetic strip (4) are the same.

5. The modular placemark for robot movement according to any one of claims 1-4, wherein the magnetic strips are directly pasted onto the respective modular zones.

6. The modular placemark for robot movement according to any one of claims 1-4, wherein each of the modular zones is provided with a magnetic material plate, wherein the magnetic material plate is directly magnetized to form the north-pole magnetic strip or south-pole magnetic strip.

7. The modular placemark for robot movement according to any one of claims 1-4, wherein the multiple modular zones are arranged in a matrix, and each modular zone has a square shape.

8. A placemark for robot movement, **characterized by** comprising the modular placemark for robot movement according to any one of claims 1-7, and further comprising address placemarks (5), wherein each of the modular zones is provided with a different address placemark (5).

9. The placemark for robot movement according to claim 8, wherein the address placemark (5) is a bar code, a two-dimensional code, a graphic mark, a color mark, a size mark, or an RFID mark.

10. A robot, moving on the placemark for robot movement according to either one of claims 8 and 9, **characterized in that** a plurality of magnetic induction sensors and an address placemark identification device are mounted at a bottom of the robot, wherein the plurality of magnetic induction sensors can collect signals of the magnetic strips having different polarities, the address placemark identification device can collect information on the address placemarks, the plurality of magnetic induction sensors and the address placemark identification device are connected with a robot controller, and the robot is configured to move forward, move backward and/or make a turn according to instructions and the collected information on the address placemarks, to reach a target modular zone.

11. The robot according to claim 10, wherein the plurality of magnetic induction sensors are Hall sensors (6).

12. The robot according to claim 10, wherein the address placemark identification device is a camera or an RFID card reader.

13. The robot according to claim 11 or 12, wherein the plurality of Hall sensors are arranged in a form of square, and the address placemark identification device is located at a center of the square.

14. The robot according to claim 13, further comprising a low-remanence high-permeability material plate (7), the Hall sensors (6) are mounted to be close to the respective modular zones, and the low-remanence high-permeability material plate (7) is fixed above the Hall sensors (6) and close to the Hall sensors (6).

15. The robot according to claim 10, wherein the robot comprises a sorting robot and/or a robot for transporting and unloading goods, wherein the sorting robot and/or the robot for transporting and unloading goods are wirelessly connected with a server, and after receiving an instruction signal, move forward, move backward, and/or make a turn along a predetermined route to reach a target modular zone to load or unload goods.
